# FASCICULE DE BREVET EUROPEEN

(11) **EP 1 768 477 B1**
(45) Date de publication et mention de la délivrance du brevet: **20.02.2008**
(21) Numéro de dépôt: 06291494.0
(22) Date de dépôt: 22.09.2006
(51) Int. Cl.: H05K 7/14

(54) **Système de maintien en position d'un assemblage à trois parties assurant un effort de compression prédéterminé sur la partie intermédiaire**
Halterungssytem für eine dreiteilige Zusammensetzung, das eine vorbestimmte Druckkraft auf das Zwischenteil aufbringt
Position holding system of three parts assembly applying predetermined compression force to intermediary part

(30) Priorité: 23.09.2005 FR 0509738
(43) Date de publication de la demande: 28.03.2007
(73) Titulaire: Bull S.A.S., 78340 Les Clayes sous Bois (FR)
(72) Inventeur: Coutancier, Lionel, 28210 Croisilles (FR); Magnoux, Sébastien, 95210 Saint Gratien (FR)
(74) Mandataire: Pellegrini, Marie Claude

(56) Documents cités:
- DE-A1- 3 013 517
- US-A- 5 706 965
- US-A1- 2003 161 114
- US-A1- 2003 161 130

## Description

La présente invention est relative au domaine des dispositifs d'assemblage et de solidarisation de serveur informatique en plusieurs parties avec un verrouillage centralisé. L'invention concerne plus particulièrement un système de maintien en position d'un assemblage à trois parties assurant un effort de compression prédéterminé sur la partie intermédiaire.

Dans le domaine des serveurs informatiques, les procédés classiques de solidarisation d'un assemblage n'utilisent que deux blocs seulement pour monter un tiroir dans une armoire informatique. La partie arrière se fixe sur l'ossature de la baie ou armoire et assure le câblage de l'assemblage vers l'arrière de la baie. Les deux blocs, pouvant être assimilés à des boîtiers, sont solidarisés et sont reliés entre eux par l'intermédiaire de connecteurs. La continuité des signaux peut être assurée d'un boîtier à l'autre lorsque les blocs sont maintenus solidarisés.

Il peut aussi être envisagé d'assembler trois blocs avec un bloc intermédiaire fixé par des vis ou des moyens de fixation analogues aux deux blocs extérieurs. Toutefois, de nombreux inconvénients seraient rencontrés pour l'opérateur :
- une fois l'assemblage du serveur effectué, l'accessibilité aux vis est délicate puisqu'elles se trouvent au fond des boîtiers extérieurs ;
- il faut pouvoir accéder aux deux cotés opposés du serveur, ce qui complique la tache (coût de maintenance augmenté) lorsque le serveur assemblé se trouve dans une armoire qui est au milieu d'une rangée dans une salle informatique ;
- la résistance et la rigidité de l'assemblage dépendent de l'épaisseur des parois du boîtier intermédiaire et de la taille des vis (poids et habitabilité des boîtiers) ;
- le couple de serrage des vis doit être maîtrisé, or les techniciens de maintenance informatique ne possèdent pas en général de clé dynamométrique ;
- les vis/attaches peuvent être perdues,
- les vis/attaches sont encombrantes dans les boîtiers.

Les inventeurs ont eu initialement l'idée d'utiliser un système de fixation qui s'étend, par des tirants par exemple, à travers le boîtier intermédiaire pour n'utiliser des moyens de fixation de type écrous que dans un des boîtiers extérieurs. Toutefois l'accessibilité aux fixations reste difficile. En outre, un tel système est encombrant et il n'est pas facile d'ajuster l'effort de compression auquel le boîtier intermédiaire est soumis. C'est pourquoi, les inventeurs ont du imaginer un autre type de solution, permettant une maintenance plus aisée et un mode de connexion ajusté entre les boîtiers.

La présente invention a pour objectif de pallier un ou plusieurs des inconvénients de l'art antérieur, en proposant un système de maintien en position d'un assemblage à trois parties alignées qui soit plus pratique à mettre en oeuvre. Dans tout ce qui suit, il faut comprendre que la partie intermédiaire peut être elle-même constituée de plusieurs sous-parties, indépendantes ou non.

Un objectif supplémentaire de l'invention est de proposer un mode d'assemblage sans outil, permettant de maîtriser facilement l'effort de serrage sur la partie intermédiaire.

Ces objectifs sont atteints par un système de maintien en position d'un assemblage à trois parties alignées, comprenant au moins un dispositif de verrouillage pour recevoir un organe d'attache solidaire d'une première partie de l'assemblage dite partie arrière, caractérisé en ce que le dispositif de verrouillage, apte à coulisser sur l'organe d'attache, est monté dans une seconde partie de l'assemblage dite partie avant et solidarisé par des moyens de rappel élastique à la partie avant, ledit système comprenant en outre :
- des moyens de déplacement du dispositif de verrouillage agencés, lorsque les parties de l'assemblage sont en contact ou adjacentes les unes avec les autres, pour se mettre en prise avec un élément d'accrochage de l'organe d'attache et entraîner un déplacement du dispositif de verrouillage vers l'arrière, d'une première position de repos vers une seconde position de plus grande sollicitation des moyens de rappel élastique dans laquelle ces derniers exercent une force de rappel vers l'avant sur le dispositif de verrouillage ; et
- des moyens de blocage dans le dispositif de verrouillage pour bloquer l'organe d'attache lorsque le dispositif de verrouillage occupe la seconde position, la partie intermédiaire de l'assemblage étant prise en étau entre la partie avant et la partie arrière dans cette seconde position.

Ainsi, l'invention propose avantageusement un maintien entre les parties de l'assemblage avec un effort de compression prédéterminé sur la partie intermédiaire.

Selon une autre particularité, lesdits moyens de déplacement sont actionnables pour dégager l'élément d'accrochage et permettre le retour du dispositif de verrouillage à sa première position.

Ainsi, l'invention propose un mécanisme centralisé, pratique et simple d'utilisation, sans nécessité d'avoir accès à l'arrière de l'asssemblage.

Selon une autre particularité, les moyens de blocage comportent au moins un verrou à encliquetage prévu pour recevoir un pion de verrou disposé à une extrémité de l'organe de butée, le verrou comprenant un organe de butée monté mobile en rotation entre une position d'ouverture du verrou permettant la réception du pion de verrou et une position de fermeture du verrou permettant de bloquer ledit pion de verrou.

Selon une autre particularité, les moyens de blocage comportent un doigt prévu dans un levier pivotant selon un axe transversal par rapport à l'alignement de l'assemblage, le doigt étant mobile en rotation entre une position levée permettant un coulissement relatif du dispositif de verrouillage par rapport à l'organe d'attache solidaire de la partie arrière et une position abaissée dans laquelle le doigt permet, lorsque les parties de l'assemblage sont en contact les unes avec les autres, de bloquer un pion de levier formé sur l'organe d'attache.

Selon une autre particularité, l'organe d'attache est allongé suivant la direction d'alignement de l'assemblage et comprend à une extrémité libre le pion de verrou, le pion de levier étant disposé en retrait par rapport au pion de verrou.

Selon une autre particularité, les moyens de déplacement du dispositif de verrouillage comportent un levier qui est actionnable manuellement, les moyens de rappel élastique comprenant au moins un ressort de raideur et de compression déterminées pour assurer une compression prédéterminée sur la partie intermédiaire lorsque le dispositif de verrouillage est placé dans sa seconde position.

Selon une autre particularité, l'organe d'attache forme une partie fixe de glissière, sur laquelle coulisse notamment la partie intermédiaire et le dispositif de verrouillage, l'organe d'attache étant fixé latéralement sur la partie arrière de l'assemblage et s'étendant sur une longueur supérieure à l'espacement intermédiaire occupé par la partie intermédiaire de l'assemblage.

Selon une autre particularité, des pions de positionnement sont disposés entre la partie arrière et la partie intermédiaire d'une part, et entre la partie intermédiaire et la et la partie avant d'autre part, pour permettre un contact planaire entre la partie intermédiaire et les deux autres parties de l'assemblage.

Selon une autre particularité, le dispositif de verrouillage comprend un chariot doté de rainures pour coulisser dans un boîtier en tôle délimitant la partie avant, les moyens de rappel élastique étant fixés à une première extrémité sur une patte d'appui solidaire du chariot, et à une deuxième extrémité à une face de la partie avant destinée à être en contact avec la partie intermédiaire de l'assemblage, ces moyens de rappel élastique comprenant des ressorts qui s'étendent, dans ladite position de repos, sur une longueur comprise entre 7 et 20 cm suivant la direction d'alignement de l'assemblage.

Un autre objet de l'invention est de proposer une utilisation du système dans le domaine de l'assemblage de serveurs informatiques dotés de plusieurs parties (boîtiers).

A cet effet, l'invention propose une utilisation du système selon l'invention, caractérisée en ce que le système sert à assembler et maintenir en position des parties d'un assemblage dans un emplacement directement accessible uniquement par un côté.

Selon une autre particularité, le système sert à assembler et maintenir en position des parties d'un serveur dans une baie informatique.

Selon une autre particularité, l'utilisation selon l'invention comprend :
- un montage manuel pour aligner les parties de l'assemblage ;
- une mise en contact deux à deux des parties de l'assemblage permettant de positionner une extrémité libre de l'organe d'attache, solidaire de la partie arrière, dans un logement du dispositif de verrouillage ;
- un actionnement dans un premier sens des moyens de déplacement du dispositif de verrouillage pour translater ie dispositif de verrouillage et comprimer au moins un ressort des moyens élastiques de rappel ; et
- un verrouillage à l'aide des moyens de blocage du dispositif de verrouillage pour maintenir la compression des ressorts.

Selon une autre particularité, un déverrouillage est effectué par actionnement des moyens de déplacement du dispositif de verrouillage, dans un second sens opposé au premier sens, pour translater le dispositif de verrouillage de façon à décomprimer le ou les ressorts.

Un autre objet de l'invention est de proposer un boîtier formant partie avant d'un serveur qui soit adapté pour faciliter la fixation des parties du serveur et leur maintien en position de connexion.

A cet effet, l'invention propose un boîtier d'extrémité avant d'un ensemble serveur à plusieurs parties en tiroir alignées, comprenant au moins un dispositif de verrouillage pour recevoir un organe d'attache de type glissière solidaire d'une partie opposée du serveur dite partie arrière, caractérisé en ce que le dispositif de verrouillage, apte à coulisser sur l'organe d'attache, est solidarisé par des moyens de rappel élastique au boîtier, le dispositif de verrouillage comprenant en outre :
- des moyens de déplacement agencés pour s'engager avec l'organe d'attache et entraîner un déplacement du dispositif de verrouillage d'une première position de repos vers une seconde position de plus grande sollicitation des moyens de rappel élastique dans laquelle ces derniers exercent sur le dispositif de verrouillage une force de rappel dirigée vers l'avant du serveur ; et
- des moyens de blocage pour bloquer l'organe d'attache lorsque le dispositif de verrouillage occupe la seconde position.

L'invention, avec ses caractéristiques et avantages, ressortira plus clairement à la lecture de la description faite en référence aux dessins annexés dans lesquels:
- la figure 1 montre une vue de côté illustrant la phase de montage permise avec le système selon l'invention,
- la figure 2 montre une vue de côté illustrant le système selon l'invention lors d'une phase de début d'actionnement du levier,
- la figure 3 montre une vue de côté illustrant la phase de compression permise avec le système selon l'invention,
- la figure 4 montre une vue de côté illustrant la phase de verrouillage permise avec le système selon l'invention,
- la figure 5 représente avec une vue éclatée un agencement du dispositif de verrouillage selon un mode de réalisation de l'invention,
- les figures 6A et 6B illustre schématiquement, respectivement avant serrage et après serrage, la prise en étau de la partie intermédiaire de l'assemblage, avec un effort de serrage uniquement exercé par un système à ressort,
- la figure 7 représente en perspective un boîtier d'extrémité avant selon l'invention intégrant le dispositif de verrouillage,
- la figure 8 illustre schématiquement l'alignement des parties ou boîtiers de type tiroir d'un serveur.

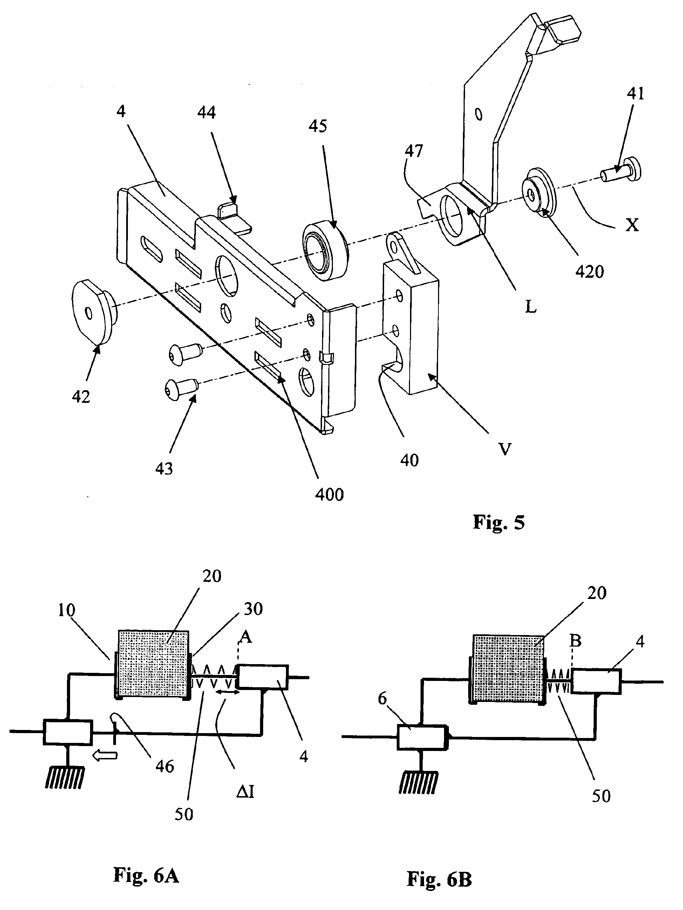

Dans tout ce qui suit, on entendra par baie informatique toute structure de type haute densité avec un matériel permettant une utilisation dans des centres de données, des salles réseau ou des armoires de câblage. L'invention s'applique avantageusement aux serveurs devant être installés dans des baies informatiques, mais peut tout aussi bien être utilisée pour tout type d'assemblage avec trois blocs alignés (10, 20, 30) devant être maintenus connectés, comme illustré aux figures 6A et 6B.

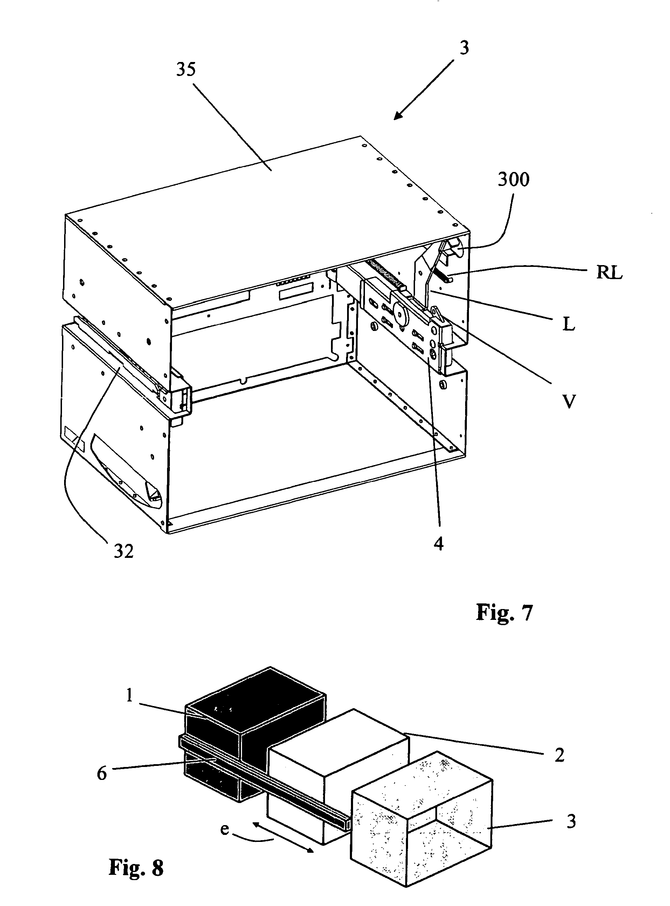

En référence à la figure 8, l'assemblage peut être constitué de trois parties (1, 2, 3) assimilables à des boîtiers et formant un tiroir, coulissant sur des glissières montées sur la partie (1) formant le boîtier arrière. Dans un mode de réalisation de l'invention, le tiroir doit pouvoir être monté dans une baie informatique. Ces baies ont un coté avant, et un coté arrière dans lequel descendent tous les câbles (appelé zone de câblage). De manière classique dans ce domaine, les tiroirs sont conçus pour être montés toujours dans le même sens dans les armoires; avec les sorties de câbles dans la zone de câblage. On distingue donc sur tous les tiroirs le coté avant et le coté arrière. Lorsque la machine formant serveur informatique est assemblée, les trois parties (1, 2, 3) comportent des cartes électroniques et les connecteurs placés dans les plans de liaisons entre les trois parties permettent d'assurer la continuité des signaux informatiques d'un boîtier à l'autre.

On comprend que le boîtier (3) d'extrémité avant illustré à la figure 8 est le côté le plus accessible pour un opérateur, une fois le tiroir monté dans la baie informatique. Les faces extérieures des parties avant et arrière peuvent être démontées pour effectuer des opérations de maintenance. Lorsque le tiroir est monté dans une armoire ou baie informatique, la partie arrière (1) est fixée sur l'ossature de la baie, par exemple via des glissières pour pouvoir sortir partiellement le module vers l'avant et vers l'arrière et ainsi faciliter certaines opérations de maintenance. Du point de vue du mécanisme de solidarisation des trois parties (1, 2, 3), la partie arrière (1) peut alors être considérée comme la partie fixe.

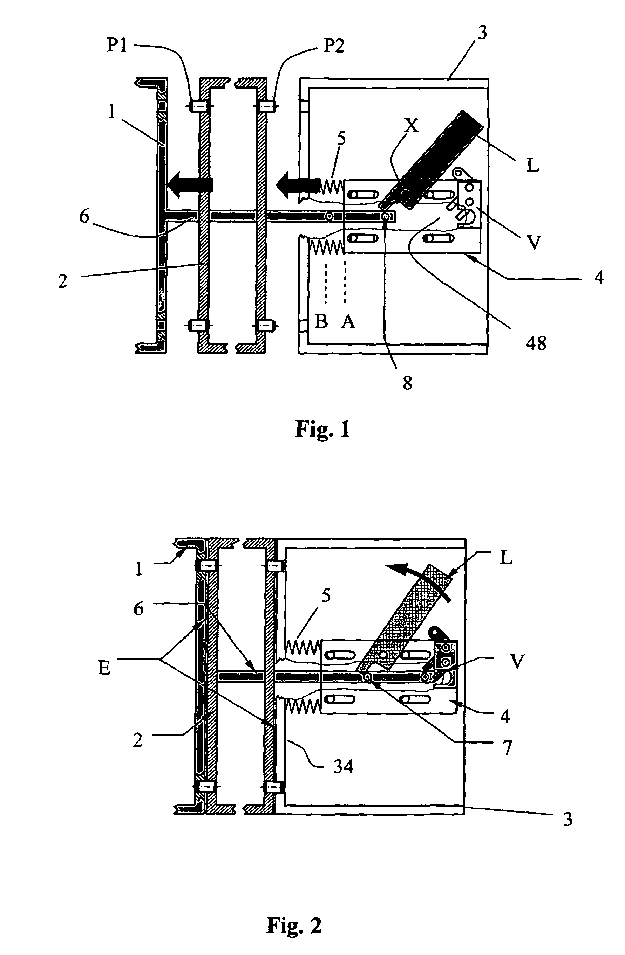

En référence aux figures 1 à 4, le système selon l'invention de maintien en position d'un tel assemblage comprend une commande centralisée permettant à la fois d'assurer la connexion entre les parties (1, 2, 3) de l'assemblage et de maintenir serrée la partie intermédiaire (2), prise en étau entre la partie avant (3) et la partie arrière (1).

Comme illustré à la figure 1, les trois parties (1, 2, 3) sont montées de façon alignée à l'aide notamment d'un organe d'attache (6) solidaire de la partie arrière (1). Dans un mode de réalisation préféré de l'invention, l'organe d'attache (6) est allongé suivant la direction d'alignement de l'assemblage et peut constituer une partie fixe de glissière. Les parties (2, 3) mobiles disposent par exemple d'une gorge adaptée pour coulisser sur l'organe d'attache (6) fixe solidarisé à la partie arrière (1). Le montage illustré à la figure 1 peut consister à aligner puis rapprocher les parties mobiles (2, 3) de la partie arrière (1) fixe. La partie arrière (1) est par exemple préalablement câblée et fixée à l'arrière d'une baie informatique (non représentée).

Le système de maintien en position de l'assemblage est doté d'au moins un dispositif (4) de verrouillage pour recevoir l'organe d'attache (6). Ce dispositif (4) peut être apte à coulisser sur l'organe d'attache (6). Le dispositif (4) de verrouillage peut être monté dans le boîtier formant la partie avant (1), comme illustré à la figure 7. Le coulissement du dispositif (4) de verrouillage se fait par exemple via une ou plusieurs gorges (32) disposées latéralement sur l'extérieur d'un boîtier. Une partie fixe de glissière reliée à la partie arrière (1) s'insère dans cette gorge (32). Les parties mobiles (2, 3) peuvent comporter de telles gorges (32) pour permettre leur coulissement à la façon d'un tiroir.

Dans l'exemple des figures 1 à 4, la partie intermédiaire (2) et le dispositif (4) de verrouillage coulissent sur l'organe d'attache (6). Ce dernier est fixé latéralement sur la partie arrière (1) de l'assemblage et s'étend sur une longueur supérieure à l'espacement intermédiaire (e) occupé par la partie intermédiaire (2) de l'assemblage. Des parties fixes de coulissement peuvent être prévues latéralement, de part et d'autre des parties (1, 2, 3) de l'assemblage pour pénétrer dans des gorges correspondantes (32, figure 7).

En référence aux figures 1 à 4, le dispositif (4) de verrouillage est monté dans la partie avant (3) et solidarisé notamment par des moyens de rappel élastique (5) à cette partie avant (3). Pour une utilisation du système selon l'invention dans une baie informatique, il est avantageux de placer le dispositif (4) de verrouillage sur un côté directement accessible par un opérateur (côté avant en l'occurrence) pour réduire le temps de démontage-remontage. Le dispositif (4) de verrouillage est mobile en translation par rapport au boîtier de la partie (3) sur laquelle il est monté, entre une première position (A) de repos et au moins une seconde position (B) pour laquelle les moyens de rappel élastiques sont sollicités plus fortement et exercent une force de rappel sur le dispositif (4) de verrouillage, vers l'avant de l'assemblage. Le dispositif (4) de verrouillage peut être ainsi déplacé par poussée pour solliciter les moyens de rappel élastique (5) disposés par exemple longitudinalement entre une face arrière (34) de la partie avant (3) et le dispositif (4) de verrouillage.

De manière non limitative, le dispositif (4) de verrouillage peut comporter un chariot doté de rainures (400) pour coulisser dans un boîtier en tôle (35) délimitant la partie avant (3). Les moyens de rappel élastique (5) comprennent par exemple un ou plusieurs ressorts fixés à une première extrémité sur une patte d'appui (44) solidaire du chariot, et à une deuxième extrémité à une face de la partie avant (3) destinée à être en contact avec la partie intermédiaire (2) de l'assemblage. Ces ressorts s'étendent suivant la direction d'alignement de l'assemblage, sur une longueur comprise par exemple entre 7 et 20 cm dans ladite position de repos (A). La raideur des ressorts peut être de l'ordre de 10 N/mm.

Le système selon l'invention prévoit des moyens de déplacement (L, 47) du dispositif (4) de verrouillage, pouvant être actionnés manuellement, pour pousser le dispositif (4) de verrouillage de façon à solliciter les moyens de rappel (5). Ces moyens de déplacement (L, 47) sont agencés pour se mettre en prise avec un élément d'accrochage de l'organe d'attache (6), lorsque les parties (1, 2, 3) de l'assemblage sont en contact ou adjacentes les unes avec les autres. La disposition de l'organe d'attache et de ces moyens de déplacement (L, 47) est déterminée pour qu'ils puissent coopérer lorsque les parties (1, 2, 3) de l'assemblage sont sommairement accolées, comme représenté à la figure 2. Lesdits moyens de déplacement (L, 47) permettent alors d'entraîner un déplacement en translation du dispositif (4) de verrouillage vers l'arrière. Dans le mode de réalisation des figures 1 à 4, le dispositif (4) de verrouillage comprime ainsi les ressorts reliés au boîtier délimitant la partie avant (3) jusqu'à atteindre sa seconde position (B). Des pions de positionnement (P1, P2) peuvent être disposés entre la partie arrière (1) et la partie intermédiaire (2) d'une part, et entre la partie intermédiaire (2) et la et la partie avant (3) d'autre part, pour permettre un contact planaire entre la partie intermédiaire (2) et les deux autres parties (1, 3) de l'assemblage. Ces pions sont par exemple montés sur la partie intermédiaire (2), comme illustré à la figure 1.

Des moyens de blocage (46, V) sont également prévus dans le dispositif (4) de verrouillage pour bloquer l'organe d'attache (6) lorsque le dispositif (4) de verrouillage occupe la seconde position (B). En raison de la sollicitation exercée vers l'avant par les moyens de rappel élastique (5), la partie intermédiaire (2) de l'assemblage est prise en étau entre la partie avant (3) et la partie arrière (1) lorsque le dispositif (4) de verrouillage est amené dans cette seconde position (B).

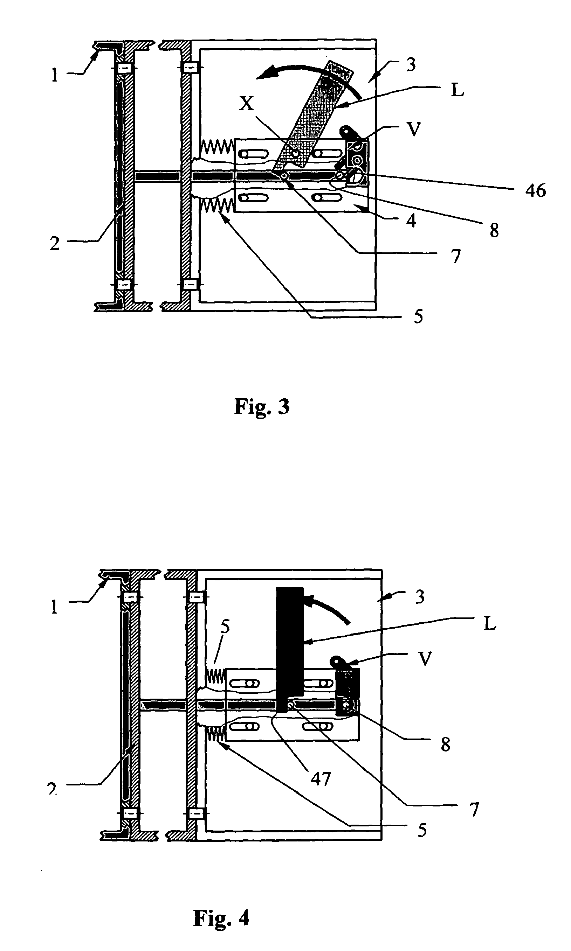

En référence aux figures 3 et 5, les moyens de blocage (46, V) comportent au moins un verrou (V) à encliquetage prévu pour recevoir un pion de verrou (8) disposé à une extrémité de l'organe de butée (6). Le verrou (V) comprend un organe de butée (46) pour recevoir ce pion de verrou. L'organe de butée est par exemple monté mobile en rotation entre une position d'ouverture du verrou (V) permettant la réception du pion de verrou (8) et une position de fermeture du verrou (V) permettant de bloquer ledit pion de verrou (8).

L'enchaînement des figures 1 à 4 illustre les différentes phases permettant de réaliser l'assemblage grâce au système selon l'invention. Ainsi, après le montage manuel pour aligner les parties (1, 2, 3) de l'assemblage conformément à la représentation de la figure 1, puis la mise en contact deux à deux des parties (1, 2, 3) de l'assemblage, l'opérateur n'a plus qu'à effectuer un verrouillage qui comprend :
- un actionnement dans un premier sens des moyens de déplacement (L, 47) du dispositif (4) de verrouillage pour translater le dispositif de verrouillage (4) et comprimer au moins un ressort des moyens élastiques de rappel (5) ; et
- un verrouillage effectif à l'aide des moyens de blocage (46, V) du dispositif (4) pour maintenir la compression des ressorts.

L'opérateur n'a donc qu'à accoler les trois parties (1, 2, 3) de façon suffisante pour que levier (L) puisse s'engager avec le pion de levier (8). Ainsi, une fois les espacements (E) entre les parties (1, 2, 3) minimisés de façon sommaire, il ne reste qu'à actionner manuellement le levier (L) jusqu'à l'obtention de l'encliquetage de façon à combler les jeux éventuels et établir une connexion fiable entre les parties, avec un effort de compression maîtrisé. Comme illustré à la figure 7, le levier (L) peut être rendu accessible à travers le boîtier en tôle (35) qui délimite la partie avant (3), à travers une découpe (300) appropriée, tandis que le dispositif de verrouillage est intégré à l'intérieur du volume du boîtier (35). Un ressort (RL) de retour du levier (L) en position initiale peut aussi être disposé le long de la paroi intérieure du boîtier (35).

Les moyens de déplacement (L, 47) du dispositif (4) de verrouillage peuvent être actionnés pour dégager l'élément d'accrochage de l'organe d'attache (6) et entraîner le retour du dispositif (4) de verrouillage à sa première position (A). Un déverrouillage est ainsi permis, par simple actionnement des moyens de déplacement (L, 47) du dispositif (4) de verrouillage, dans un second sens opposé au premier sens, pour translater le dispositif de verrouillage (4) de façon à décomprimer le ou les ressorts

Dans le mode de réalisation des figures 1 à 5, ces moyens de déplacement comportent un levier (L) qui est actionnable manuellement. Ce type de levier peut être doté, par exemple dans sa partie inférieure, d'un doigt (47, Fig. 4) pivotant avec le levier (L) selon un axe (X) transversal par rapport à l'alignement de l'assemblage. Le blocage du dispositif (4) de verrouillage dans sa seconde position (B) est permis notamment grâce à ce doigt (47) qui est mobile en rotation entre une position levée permettant un coulissement relatif du dispositif de verrouillage (4) par rapport à l'organe d'attache (6) solidaire de la partie arrière (1) et une position abaissée. Cette position abaissée du doigt (47) permet, lorsque les parties (1, 2, 3) de l'assemblage sont en contact les unes avec les autres, de bloquer le pion de levier (7) formé sur l'organe d'attache (6). Naturellement, la disposition du pion de levier (7) est prédéterminée, comme illustré dans les figures 2 à 4, pour que la position de ce pion (7) coïncide avec le doigt lorsque l'assemblage des trois parties (1, 2, 3) est formé.

En référence à la figure 3, la phase de compression peut être ensuite entamée, par action sur le levier (L), pour permettre de pousser le dispositif (4) de verrouillage. La poussée exercée sur le dispositif (4) de verrouillage permet de faire rentrer l'organe d'attache (6) complètement dans le logement (48) du dispositif (4) de verrouillage, jusqu'à l'organe de butée (46). Le pion de verrou (8) situé à l'extrémité libre de l'organe d'attache (6) est alors bloqué par le verrou (V), comme illustré à la figure 4. Le levier (L) occupe une position verticale et le doigt (47) est disposé en arrière du pion de levier (7). Autrement dit, l'organe d'attache est maintenu d'une part grâce au doigt (47) du levier (L), et d'autre part par le verrou (V). Le pion de levier (7) est disposé en retrait par rapport au pion de verrou, à une distance de quelques centimètres par exemple.

Comme illustré notamment aux figures 4 et 6B, les moyens de rappel élastique (5) comprennent au moins un ressort de raideur et de compression (ΔI) déterminées pour assurer cette compression prédéterminée sur la partie ou bloc intermédiaire (2, 20) de l'assemblage lorsque le dispositif (4) de verrouillage est placé dans sa seconde position (B). Dans la seconde position (B), l'effort de serrage de "l'étau" est toujours maîtrisé grâce au système de l'invention. En effet, celui-ci ne dépend que de la raideur du ressort, de la compression du ressort (ΔI) et du nombre de ressorts utilisés (les ressorts pouvant être choisis identiques).

Dans le mode de réalisation de la figure 5, le dispositif (4) de verrouillage se déplace relativement à la partie avant (3) grâce à des rainures (400) délimitant un intervalle autorisé de translation. Ces rainures (400) sont traversées par des pions ou parties mâles équivalentes formés sur un guide du dispositif (4). Le guide est monté sur la partie avant (3) et peut permettre de délimiter les positions (A, B) extrêmes pouvant être prises par le dispositif (4) de verrouillage. Le verrou (V) est solidarisé de la partie chariot du dispositif (4) par des vis (43) ou tout autre moyen de fixation équivalent. Le levier (L) est monté rotatif sur cette partie chariot suivant l'axe (X) de pivotement. Une rondelle lamée (420) et un écrou spécifique permettent, en combinaison avec une vis de montage de solidariser le levier à la partie chariot. Un canon de levier (45) est disposé en outre contre la zone perforée du levier (V).

Un des avantages de l'invention est de permettre un montage et un démontage du serveur sans outil, même lorsque celui-ci est installé dans une baie, par une simple action sur le levier (L) commandant de façon centralisée la fixation entre les blocs du serveur. Ainsi, les temps de maintenance sont réduits grâce au mécanisme centralisé de maintien en position des trois parties (1, 2, 3), qui est accessible par un côté du tiroir serveur (ce sera le côté le plus facilement accessible, correspondant en général au côté avant).

Un autre des avantages de l'invention est de fournir une solution qui prend en compte toutes les contraintes d'assemblage et de connexion d'un tiroir serveur en trois parties. Ainsi, les parties (1, 2, 3) peuvent être accolées avec une rigidité de l'assemblage suffisante pour assurer des connexions stables entre les cartes. La résistance mécanique de l'ensemble est assurée et l'effort de compression auquel est soumise la partie centrale ou intermédiaire (2) est maîtrisé.

Le système selon l'invention peut servir par exemple à assembler et maintenir en position des parties (1, 2, 3) d'un assemblage dans un emplacement qui est accessible directement uniquement par un côté. En particulier, on comprend que le système permet d'assembler et maintenir en position des parties (1, 2, 3) d'un serveur dans une baie informatique.

Il doit être évident pour les personnes versées dans l'art que la présente invention permet des modes de réalisation sous de nombreuses autres formes spécifiques sans l'éloigner du domaine d'application de l'invention comme revendiqué, l'invention ne devant pas être limitée aux détails donnés ci-dessus.

## Revendications

1. Système de maintien en position d'un assemblage, en particulier de serveur informatique, à trois parties (1, 2, 3) alignées, comprenant au moins un dispositif (4) de verrouillage pour recevoir un organe d'attache (6) de type glissière, solidaire d'une première partie de l'assemblage dite partie arrière (1) et allongé suivant la direction d'alignement de l'assemblage, **caractérisé en ce que** le dispositif (4) de verrouillage, apte à coulisser sur l'organe d'attache (6), est monté dans une seconde partie de l'assemblage dite partie avant (3) et solidarisé par des moyens de rappel élastique (5) à la partie avant (3), ledit système comprenant en outre :
- des moyens de déplacement (L, 47) du dispositif (4) de verrouillage agencés, lorsque les parties (1, 2, 3) de l'assemblage sont en contact ou adjacentes les unes avec les autres, pour se mettre en prise avec un élément d'accrochage de l'organe d'attache (6) et entraîner un déplacement du dispositif (4) de verrouillage vers l'arrière, d'une première position (A) de repos vers une seconde position (B) de plus grande sollicitation des moyens de rappel élastique (5) dans laquelle ces derniers exercent une force de rappel vers l'avant sur le dispositif (4) de verrouillage ; et
- des moyens de blocage (46, V) dans le dispositif (4) de verrouillage pour bloquer l'organe d'attache (6) lorsque le dispositif (4) de verrouillage occupe la seconde position (B), la partie intermédiaire (2) de l'assemblage étant prise en étau entre la partie avant (3) et la partie arrière (1) dans cette seconde position (B).

2. Système selon la revendication 1, dans lequel lesdits moyens de déplacement (L, 47) sont actionnables pour dégager l'élément d'accrochage et permettre le retour du dispositif (4) de verrouillage à sa première position (A).

3. Système selon la revendication 1 ou 2, dans lequel les moyens de blocage (46, V) comportent au moins un verrou (V) à encliquetage prévu pour recevoir un pion de verrou (8) disposé à une extrémité de l'organe de butée (6), le verrou (V) comprenant un organe de butée (46) monté mobile en rotation entre une position d'ouverture du verrou (V) permettant la réception du pion de verrou (8) et une position de fermeture du verrou (V) permettant de bloquer ledit pion de verrou (8).

4. Système selon une des revendications 1 à 3, dans lequel les moyens de blocage (46, V) comportent un doigt (47) prévu dans un levier (L) pivotant selon un axe (X) transversal par rapport à l'alignement de l'assemblage, le doigt (47) étant mobile en rotation entre une position levée permettant un coulissement relatif du dispositif de verrouillage (4) par rapport à l'organe d'attache (6) solidaire de la partie arrière (1) et une position abaissée dans laquelle le doigt (47) permet, lorsque les parties (1, 2, 3) de l'assemblage sont en contact les unes avec les autres, de bloquer un pion de levier (7) formé sur l'organe d'attache (6).

5. Système selon la revendication 4 lorsque cette dernière dépend de la revendication 3, dans lequel l'organe d'attache (6) comprend à une extrémité libre le pion de verrou (8), le pion de levier (7) étant disposé en retrait par rapport au pion de verrou (8).

6. Système selon une des revendications 1 à 5, dans lequel les moyens de déplacement du dispositif (4) de verrouillage comportent un levier (L) qui est actionnable manuellement, les moyens de rappel élastique (5) comprenant au moins un ressort de raideur et de compression (Δl) déterminées pour assurer une compression prédéterminée sur la partie intermédiaire (2) lorsque le dispositif (4) de verrouillage est placé dans sa seconde position (B).

7. Système selon une des revendications 1 à 6, dans lequel l'organe d'attache (6) forme une partie fixe de glissière, sur laquelle coulisse notamment la partie intermédiaire (2) et le dispositif (4) de verrouillage, l'organe d'attache (6) étant fixée latéralement sur la partie arrière (1) de l'assemblage et s'étendant sur une longueur supérieure à l'espacement intermédiaire (e) occupé par la partie intermédiaire (2) de l'assemblage.

8. Système selon une des revendications 1 à 7, dans lequel des pions de positionnement (P1, P2) sont disposés entre la partie arrière (1) et la partie intermédiaire (2) d'une part, et entre la partie intermédiaire (2) et la et la partie avant (3) d'autre part, pour permettre un contact planaire entre la partie intermédiaire (2) et les deux autres parties (1, 3) de l'assemblage.

9. Système selon une des revendications 1 à 8, dans lequel le dispositif (4) de verrouillage comprend un chariot doté de rainures (400) pour coulisser dans un boîtier en tôle (35) délimitant la partie avant (3), les moyens de rappel élastique (5) étant fixés à une première extrémité sur une patte d'appui (44) solidaire du chariot, et à une deuxième extrémité à une face de la partie avant (3) destinée à être en contact avec la partie intermédiaire (2) de l'assemblage, ces moyens de rappel élastique (5) comprenant des ressorts qui s'étendent, dans ladite position de repos (A), sur une longueur comprise entre 7 et 20 cm suivant la direction d'alignement de l'assemblage.

10. Utilisation du système selon une des revendications 1 à 9, **caractérisée en ce que** le système sert à assembler et maintenir en position des parties (1, 2, 3) d'un assemblage dans un emplacement directement accessible uniquement par un côté.

11. Utilisation selon la revendication 10, dans laquelle le système sert à assembler et maintenir en position des parties (1, 2, 3) d'un serveur dans une baie informatique.

12. Utilisation selon la revendication 9 ou 10, comprenant :
- un montage manuel pour aligner les parties (1, 2, 3) de l'assemblage ;
- une mise en contact deux à deux des parties (1, 2, 3) de l'assemblage permettant de positionner une extrémité libre de l'organe d'attache (6), solidaire de la partie arrière (1), dans un logement (48) du dispositif de verrouillage (4) ;
- un actionnement dans un premier sens des moyens de déplacement du dispositif (4) de verrouillage pour translater le dispositif de verrouillage (4) et comprimer au moins un ressort des moyens élastiques de rappel (5) ; et
- un verrouillage à l'aide des moyens de blocage (46, V) du dispositif (4) de verrouillage pour maintenir la compression des ressorts.

13. Utilisation selon la revendication 12, dans laquelle un déverrouillage est effectué par actionnement des moyens de déplacement du dispositif (4) de verrouillage, dans un second sens opposé au premier sens, pour translater le dispositif de verrouillage (4) de façon à décomprimer le ou les ressorts.

14. Boîtier (35) d'extrémité avant d'un ensemble serveur à plusieurs parties en tiroir (1, 2, 3) alignées, comprenant au moins un dispositif (4) de verrouillage pour recevoir un organe d'attache (6) de type glissière solidaire d'une partie opposée du serveur dite partie arrière (1), **caractérisé en ce que** le dispositif (4) de verrouillage, apte à coulisser sur l'organe d'attache (6), est solidarisé par des moyens de rappel élastique (5) au boîtier (3), le dispositif (4) de verrouillage comprenant en outre :
- des moyens de déplacement (L, 47) agencés pour s'engager avec l'organe d'attache (6) et entraîner un déplacement du dispositif (4) de verrouillage d'une première position (A) de repos vers une seconde position (B) de plus grande sollicitation des moyens de rappel élastique (5) dans laquelle ces derniers exercent sur le dispositif (4) de verrouillage une force de rappel dirigée vers l'avant du serveur ; et
- des moyens de blocage (46, V) pour bloquer l'organe d'attache (6) lorsque le dispositif (4) de verrouillage occupe la seconde position (B) ; la partie intermédiaire (2) de l'assemblage étant prise en étau entre la partie avant (3) et la partie arrière (1) dans cette seconde position (B).

## Claims

1. System for holding in position an assembly, in particular for a computer server, with three aligned parts (1, 2, 3), comprising at least one locking device (4) for receiving a fastening member (6) of the slider type, integral with a first part of the assembly known as the rear part (1) and extended in the direction of alignment of the assembly, **characterised in that** the locking device (4), capable of sliding over the fastening member (6), is mounted in a second part of the assembly known as the front part (3) and made integral with the front part (3) by elastic return means (5), said system also comprising:
- means (L, 47) for displacement of the locking device (4) arranged, when the parts (1, 2, 3) of the assembly are in contact with or adjacent to one another, so as to come into engagement with an attachment element of the fastening member (6) and cause a rearward displacement of the locking device (4), from a first rest position (A) to a second position (B) of greater action on the electric return means (5) in which the latter exert a forward return force on the locking device (4); and
- locking means (46, V) in the locking device (4) for locking the fastening member (6) when the locking device (4) occupies the second position (B), the intermediate part (2) of the assembly being gripped in a vice between the front part (3) and the rear part (1) in this second position (B).

2. System according to Claim 1, in which said displacement means (L, 47) are actuatable to release the attachment element and allow the return of the locking device (4) to its first position (A).

3. System according to Claim 1 or 2, in which the locking means (46, V) comprise at least one snap-in bolt (V) provided to receive a bolt pin (8) arranged at one end of the stop member (6), the bolt (V) comprising a stop member (46) mounted so as to be mobile in rotation between a position of opening of the bolt (V) allowing the reception of the bolt pin (8) and a position of closure of the bolt (V) allowing said bolt pin (8) to be locked.

4. System according to one of Claims 1 to 3 in which the locking means (46, V) comprise a finger (47) provided in a lever (L) pivoting on an axis (X) transverse to the alignment of the assembly, the finger (47) being mobile in rotation between a raised position allowing relative sliding of the locking device (4) with respect to the fastening member (6) integral with the rear part (1) and a lowered position in which the finger (47) makes it possible, when the parts (1, 2, 3) of the assembly are in contact with one another, to lock a lever pin (7) formed on the fastening member (6).

5. System according to Claim 4 when the latter depends on Claim 3, in which the fastening member (6) comprises, at a free end, the bolt pin (8), the lever pin (7) being arranged so as to be recessed with respect to the bolt pin (8).

6. System according to one of Claims 1 to 5, in which the means for displacement of the locking device (4) comprise a lever (L) that can be actuated manually, the elastic return means (5) comprising at least one spring of given stiffness and compression (Δl) so as to ensure predetermined compression on the intermediate part (2) when the locking device (4) is placed in its second position (B).

7. System according to one of Claims 1 to 6, in which the fastening member (6) forms a fixed slider part, on which there slides in particular the intermediate part (2) and the locking device (4), the fastening member (6) being fixed laterally to the rear part (1) of the assembly and extending over a length greater than the intermediate spacing (e) occupied by the intermediate part (2) of the assembly.

8. System according to one of Claims 1 to 7, in which the positioning pins (P1, P2) are arranged on the one hand between the rear part (1) and the intermediate part (2) and on the other hand between the intermediate part (2) and the front part (3), in order to allow planar contact between the intermediate part (2) and the other two parts (1, 3) of the assembly.

9. System according to one of Claims 1 to 8, in which the locking device (4) comprises a carriage provided with grooves (400) for sliding within a sheet-metal casing (35) delimiting the front part (3), the elastic return means (5) being fixed at a first end to a support lug (44) integral with the carriage, and at a second end to one face of the front part (3) intended to be in contact with the intermediate part (2) of the assembly, these elastic return means (5) comprising springs that extend, in said rest position (A), over a length comprised between 7 and 20 cm in the direction of alignment of the assembly.

10. Use of the system according to one of Claims 1 to 9, **characterised in that** the system serves to assemble and hold in position parts (1, 2, 3) of an assembly in a location that is directly accessible from one side only.

11. Use according to Claim 10, in which the system serves to assemble and hold in position parts (1, 2, 3) of a server in a computer rack.

12. Use according to Claim 9 or 10, comprising:
- manual mounting in order to align the parts (1, 2, 3) of the assembly;
- putting in contact, in pairs, of the parts (1, 2, 3) of the assembly allowing a free end of the fastening member (6), integral with the rear part (1), to be positioned in a housing (48) of the locking device (4);
- actuation in a first direction of the means for displacing the locking device (4) in order to translate the locking device (4) and to compress at least one spring of the elastic return means (5); and
- locking of the locking device (4) using the locking means (46, V) in order to maintain the compression of the springs.

13. Use according to Claim 12, in which unlocking is effected by actuating the means for displacement of the locking device (4), in a second direction opposite to the first direction, in order to translate the locking device (4) so as to decompress the spring or springs.

14. Front end casing (35) of a server assembly with several aligned parts (1, 2, 3) as plug-in units, comprising at least one locking device for receiving a fastening member (6) of the slider type integral with an opposite part of the server known as the rear part (1), **characterised in that** the locking device (4), capable of sliding over the fastening member (6), is made integral with the casing (3) by elastic return means (5), the locking device (4) also comprising:
- displacement means (L, 47) arranged so as to engage with the fastening member (6) and cause a displacement of the locking device (4) from a first rest position (A) to a second position (B) of greater action on the elastic return means (5), in which the latter exert on the locking device (4) a return force directed towards the front of the server; and
- locking means (46, V) for locking the fastening member (6) when the locking device (4) occupies the second position (B); the intermediate part (2) of the assembly being gripped as in a vice between the front part (3) and the rear part (1) in this second position (B).

## Patentansprüche

1. System, um eine Baugruppe aus drei ausgerichteten Teilen (1, 2, 3), insbesondere eines Informatikservers, in Position zu halten, mit mindestens einer Verriegelungsvorrichtung (4) zum Aufnehmen eines Befestigungsorgans (6) vom Typ einer Gleitschiene, das mit einem ersten, hinteren Teil (1) genannten Teil der Baugruppe fest verbunden und entlang der Ausrichtungsrichtung der Baugruppe langgestreckt ist, **dadurch gekennzeichnet, dass** die Verriegelungsvorrichtung (4), die an dem Befestigungsorgan (6) gleiten kann, in einem zweiten, vorderen Teil genannten Teil (3) der Baugruppe angebracht und durch elastische Rückstellmittel (5) mit dem vorderen Teil (3) fest verbunden ist, wobei das System zudem folgende Elemente aufweist:
- Mittel (L, 47) zum Verstellen der Verriegelungsvorrichtung (4), welche, wenn die Teile (1, 2, 3) der Baugruppe miteinander in Kontakt stehen oder einander benachbart sind, so angeordnet sind, dass sie in ein Einhängeelement des Befestigungsorgans (6) eingreifen und ein Verstellen der Verriegelungsvorrichtung (4) nach hinten von einer ersten Ruhestellung (A) zu einer zweiten Stellung (B) mit stärkeren Beanspruchung der elastischen Rückstellmittel (5) bewirken können, in welcher letztere eine Rückstellkraft nach vorne auf die Verriegelungsvorrichtung (4) ausüben; und
- Blockierungsmittel (46, V) in der Verriegelungsvorrichtung (4), um das Befestigungsorgan (6) zu blockieren, wenn die Verriegelungsvorrichtung (4) die zweite Stellung (B) einnimmt, wobei das Zwischenteil (2) der Baugruppe in dieser zweiten Stellung B zwischen dem vorderen Teil (3) und dem hinteren Teil (1) eingeklemmt ist.

2. System nach Anspruch 1, bei welchem die Verstellmittel (L, 47) betätigt werden können, um das Befestigungsmittel freizugeben und das Rückstellen der Verriegelungsvorrichtung (4) in ihre erste Stellung (A) zu ermöglichen.

3. System nach Anspruch 1 oder 2, bei welchem die Blockierungsmittel (46, V) mindestens einen Rastriegel (V) aufweisen, der zum Aufnehmen eines Riegelstifts (8) vorgesehen ist, der an einem Ende des Befestigungsorgans (6) angeordnet ist, wobei der Riegel (V) einen Anschlag (46) aufweist, der drehbeweglich zwischen einer Öffnungsstellung des Riegels (V), die das Aufnehmen des Riegelstifts (8) ermöglicht, und einer Schließstellung des Riegels (V), die das Blockieren des Riegelstifts (8) ermöglicht, angebracht ist.

4. System nach einem der Ansprüche 1 bis 3, bei welchem die Blockierungsmittel (46, V) einen Finger (47) aufweisen, der in einem Hebel (L) vorgesehen ist, der entlang einer zur Ausrichtung der Baugruppe querliegenden Achse (X) schwenkt, wobei der Finger (47) zwischen einer angehobenen Stellung, die ein relatives Gleiten der Verriegelungsvorrichtung (4) bezüglich des mit dem hinteren Teil (1) fest verbundenen Befestigungsorgans (6) ermöglicht, und einer abgesenkten Stellung drehbeweglich ist, in welcher der Finger (47) es ermöglicht, einen am Befestigungsorgan (6) ausgebildeten Hebelstift (7) zu blockieren, wenn die Teile (1, 2, 3) der Baugruppe miteinander in Kontakt stehen.

5. System nach Anspruch 4, wenn sich dieser auf Anspruch 3 zurückbezieht, bei dem das Befestigungsorgan (6) an einem freien Ende den Riegelstift (8) aufweist, wobei der Hebelstift (7) mit einem Rücksprung zum Riegelstift (8) angeordnet ist.

6. System nach einem der Ansprüche 1 bis 5, bei welchem die Mittel zum Verlagern der Verriegelungsvorrichtung (4) einen Hebel (L) aufweisen, der manuell betätigbar ist, wobei die elastischen Rückstellmittel (5) mindestens eine Feder mit bestimmter Steifigkeit und bestimmter Komprimierung (Δl) aufweisen, um auf das Zwischenteil (2) einen vorbestimmten Druck auszuüben, wenn die Verriegelungsvorrichtung (4) in ihrer zweiten Stellung (B) gebracht ist.

7. System nach einem der Ansprüche 1 bis 6, bei dem das Befestigungsorgan (6) einen festen Gleitschienenteil bildet, auf dem insbesondere das Zwischenteil (2) und die Verriegelungsvorrichtung (4) gleiten, wobei das Befestigungsorgan (6) seitlich am hinteren Teil (1) der Baugruppe befestigt ist und sich über eine Länge erstreckt, die größer ist als der Zwischenraum (e), den das Zwischenteil (2) der Baugruppe einnimmt.

8. System nach einem der Ansprüche 1 bis 7, bei dem Positionierungsstifte (P1, P2) zwischen dem hinteren Teil (1) und dem Zwischenteil (2) einerseits und dem Zwischenteil (2) und dem vorderen Teil (3) andererseits angeordnet sind, um einen Flächenkontakt zwischen dem Zwischenteil (2) und den beiden anderen Teilen (1, 3) der Baugruppe zu ermöglichen.

9. System nach einem der Ansprüche 1 bis 8, bei dem die Verriegelungsvorrichtung (4) einen Schlitten aufweist, der mit Schlitzen (400) versehen ist, um in einem Blechgehäuse (35) zu gleiten, das das vordere Teil (3) begrenzt, wobei die elastischen Rückstellmittel (5) an einem ersten Ende auf einer mit dem Schlitten fest verbundenen Stützlasche (44) und an einem zweiten Ende auf einer Seite des vorderen Teils (3) befestigt sind, welche dazu vorgesehen ist, mit dem Zwischenteil (2) der Baugruppe in Kontakt zu stehen, wobei diese elastischen Rückstellmittel (5) Federn aufweisen, die sich in der Ruhestellung (A) auf eine Länge zwischen 7 und 20 cm entlang der Ausrichtungsrichtung der Baugruppe erstrecken.

10. Verwendung des System nach einem der Ansprüche 1 bis 9, **dadurch gekennzeichnet, dass** das System dazu dient, Teile (1, 2, 3) einer Baugruppe an einem nur von einer Seite direkt zugänglichen Ort zusammenzufügen und zusammen zu halten.

11. Verwendung nach Anspruch 10, bei welcher das System dazu dient, Teile (1, 2, 3) eines Servers in einem Informatikrack zusammenzufügen und zusammen zu halten.

12. Verwendung nach Anspruch 9 oder 10, bei der
- die Teile (1, 2, 3) der Baugruppe manuell eingebaut werden, um sie auszurichten;
- die Teile (1, 2, 3) der Baugruppe paarweise in Kontakt gebracht werden, um das Positionieren eines mit dem hinteren Teil (1) fest verbundenen freien Endes des Befestigungsorgans (6) in einer Aufnahme (48) der Verriegelungsvorrichtung (4) zu ermöglichen;
- die Mittel zum Verlagern der Verriegelungsvorrichtung (4) in eine erste Richtung betätigt werden, um die Verriegelungsvorrichtung (4) translatorisch zu verschieben und mindestens eine Feder der elastischen Rückstellmittel (5) komprimieren; und
- die Verriegelungsvorrichtung (4) mit Hilfe der Blockierungsmittel (46, V) verriegelt wird, um die Komprimierung der Federn zu halten.

13. Verwendung nach Anspruch 12, bei der eine Entriegelung durch Betätigen der Mittel zum Verlagern der Verriegelungsvorrichtung (4) in einer zweiten, gegenüber der ersten Richtung entgegensetzten Richtung erfolgt, um die Verriegelungsvorrichtung (4) translatorisch zu verschieben, so dass die Feder(n) entspannt wird/werden.

14. Gehäuse (35) für das vordere Ende einer Server-Baugruppe mit mehreren schubladenartig in einer Reihe aufgestellten Teilen (1, 2, 3), mit mindestens einer Verriegelungsvorrichtung (4), um ein Befestigungsorgan (6) vom Typ einer Gleitschiene aufzunehmen, das mit einem gegenüberliegenden, hinteren Teil (1) genannten Teil des Servers fest verbunden ist, **dadurch gekennzeichnet, dass** die Verriegelungsvorrichtung (4), die auf dem Befestigungsorgan (6) gleiten kann, durch elastische Rückstellmittel (5) mit dem Gehäuse (3) fest verbunden ist, wobei die Verriegelungsvorrichtung (4) zudem folgende Mittel aufweist:
- Verlagerungsmittel (L, 47), die so angeordnet sind, dass sie in das Befestigungsorgan (6) eingreifen und eine Verlagerung der Verriegelungsvorrichtung (4) von einer ersten Ruhestellung (A) in eine zweite Stellung (B) zur weiteren Beanspruchung der elastischen Rückstellmittel (5) bewirken, in welcher diese auf die Verriegelungsvorrichtung (4) eine zum vorderen Teil des Servers gerichteten Rückstellkraft ausüben; und
- Blockierungsmittel (46, V), um das Befestigungsorgan (6) zu blockieren, wenn die Verriegelungsvorrichtung (4) die zweite Stellung (B) einnimmt; wobei das Zwischenteil (2) der Baugruppe in dieser zweiten Stellung (B) zwischen dem vorderen Teil (3) und dem hinteren Teil (1) eingeklemmt ist.
